# EUROPEAN PATENT SPECIFICATION

(11) **EP 0 926 815 B1**
(45) Date of publication and mention of the grant of the patent: **02.03.2005**
(21) Application number: 98440295.8
(22) Date of filing: 18.12.1998
(51) Int. Cl.: H03F 1/02

(54) **High-efficiency low-distortion linear power amplifier circuit for signals having a high peak power to mean power ratio and method for driving it**
Hocheffiziente verzerrungsarme lineare Leistungsverstärkerschaltung für Signale mit einer hohen Spitzenleistung-zu-Durchschnittsleistungs-Rate und Steuerverfahren dafür
Circuit amplificateur de puissance linéaire à faible distorsion et à haut rendement pour signaux à haut rapport puissance de crête / puissance moyenne et méthode de commande pour un tel circuit

(30) Priority: 24.12.1997 IT TO971141
(43) Date of publication of application: 30.06.1999
(73) Proprietor: ALCATEL, 75008 Paris (FR)
(72) Inventor: Frecassetti, Mario Giovanni Luigi, 24126 Bergamo (IT); Frigerio, Marco, 20031 Cesano Maderno (Milano) (IT); Gugliuzzo, Salvatore, 23900 Lecco (IT)
(74) Representative: Lamoureux, Bernard

(56) References cited:
- EP-A- 0 431 201
- WO-A-95/34128
- PATENT ABSTRACTS OF JAPAN vol. 016, no. 372 (E-1246), 11 August 1992 & JP 04 119707 A (UCHIYUU TSUUSHIN KISO GIJIYUTSU KENKIYUUSHIYO:KK;OTHERS: 01), 21 April 1992
- KOCH M J ET AL: "A HIGH EFFICIENCY 835 MHZ LINEAR POWER AMPLIFIER FOR DIGITAL CELLULAR TELEPHONY" GATEWAY TO NEW CONCEPTS IN VEHICULAR TECHNOLOGY, SAN FRANCISCO, MAY 1 - 3, 1989, vol. 1, no. CONF. 39, 1 May 1989, page 17/18 XP000076154 INSTITUTE OF ELECTRICAL AND ELECTRONICS ENGINEERS

## Description

This invention concerns a high-efficiency low-distortion linear power amplifier circuit for signals with a high peak power to mean power ratio, specifically a microwave amplifier circuit. Furthermore, the present invention also relates to a method for driving a linear power amplifier for signals having a high peak power to mean power ratio.

It is known for modern radio signal transmission systems to use complex modulations, such as multilevel modulations (e.g. 64 QAM with a high number of constellation points), which require very complex transmitter and receiver systems; specifically in modern digital signal transmissions, signals with high peak power to mean power ratios are to be transmitted, and in such a situation the probability that a given level will occur is inversely proportional to the number of levels.

Moreover, when these types of signals are used, the amount of distortion of the signal should be low in order to provide a good transmission quality. This requirement results in the use of class A power amplifiers, designed for a maximum peak level of the signal to be transmitted, i.e. with a very low energetic efficiency.

In WO-95/34128 a GaAsFET power amplifier is disclosed, wherein GaAsFET is biased for low level input signals with a voltage nearly half the value of the voltage supplied for high level signals; in order to reach this result the modulation envelope of the input signal is detected and its peaks are used to switch the supply from the first to the second value. The peak current from the second supply reaches the FET through a device BJT, while the low level current from the first supply flows through a diode, which is required to protect the second supply, along with a series connected inductor to overcome the diode slowness.

This system provides energy savings when operating with low level signals; however, as indicated in the above document (page 6, lines 6-15) it requires the use of a phase pre-distorting circuit (LIN) to compensate any distortions introduced by the GaAsFET. Moreover, switching between the two voltages may result in further faults.

PATENT ABSTRACT OF JAPAN, Vol. 016, no. 372 (E-1246), 11 August 1992 & JP 04 119707 (briefly, D1) relates to a circuit for improving the efficiency of an amplifier at high frequency wherein an envelope fluctuates. The circuit operates by detecting an envelope of an input signal through a first detector and controlling a voltage variable switching power supply in response to a peak detection output resulting from the detection of a peak level. The peak level is detected by a peak detector.

D1 does not provide any response linearization but has the only object of improving efficiency. In D1 only the peak level of the envelope is detected/considered by a peak detector. Such a peak level is used for controlling a voltage variable switching power supply. D1 fails to describe an arrangement wherein the bias voltage between the main electrodes of the power amplifier is driven in such a way as to precisely follow the envelope signal.

EP-A-0 431 201 (D2) is based on a feed-back arrangement between input and output in order to render the system adaptive. D2 could be considered as the sum of two different circuits, the one for providing high efficiency, the other for providing linearization. D2 realized that a voltage variable switching power supply does not provide good results in terms of distortions and that following the envelope signal is not practically possible (see D2, page 4, last paragraph). D2 proposes a different solution which is based on input signal feed-back arrangement. D2 uses the feed-back arrangement for utilizing a pre-distorcer. D2 fails to describe an arrangement wherein the bias voltage between the main electrodes of the power amplifier is driven in such a way as to precisely follow the envelope signal.

It is the object of this invention to teach how a high efficiency power amplifier circuit can be provided for signals with a high peak power to mean power ratio, which circuit not requiring a predistorter and being capable of reducing distortion automatically.

To reach such an object, the present invention provides a high-efficiency low-distortion linear power amplifier circuit for signals with a high peak power to mean power ratio, having the features resulting from the annexed main claim1 and further a method for driving a linear power amplifier for signals having a high peak power to mean power ratio according to claim 10. Further advantageous features of the present invention are set forth in the respective dependent claims. Anyway, all the claims are considered as an integral part of this description.

Other objects and advantages of this invention will become apparent from the following detailed description and annexed drawings, which are only provided by way of an explanatory and non limiting example, wherein:
- Fig. 1 shows a family of characteristic curves (I_{DS}-V_{DS}) of a FET used in an amplifier according to this invention;
- Fig. 2 shows a block diagram of a FET microwave power amplifier according to this invention;
- Fig. 3 shows a circuitry diagram of a detail of the FET microwave power amplifier according to this invention;
- Fig. 4 shows AM/PM distortion trend under two circuitry conditions;
- Fig. 5 shows the power absorbed by the amplifier under two different operating conditions.

This invention is based on the idea to operate the Class A power amplifier at a supply voltage changing as a function of the input signal envelope to keep the amplifier in a linear area at any time and keeping the supply absorbed power at the lowest possible value.

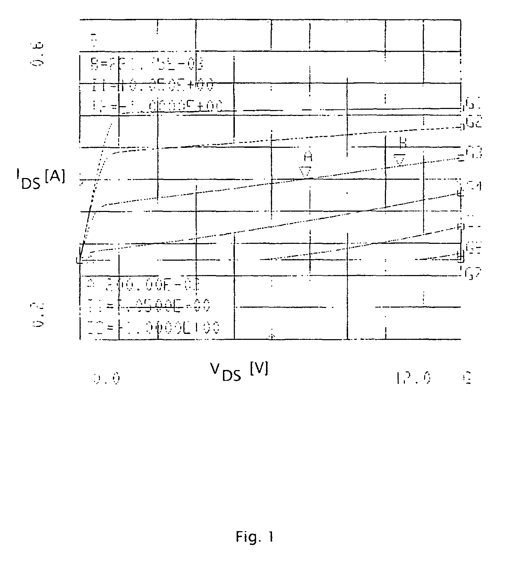

Basically, two extreme operating points have been chosen to let the amplifier operate between them, with the operating point being dynamically displaced as a function of the input signal envelope, instant by instant, from a first position (A) corresponding to the minimum supply voltage and lowest input signal level to a second position (B) corresponding to the maximum supply voltage and highest input signal level (see Fig. 1).

This not only results in the advantage of a lower consumption, but also in the advantage of reducing AM/PM distortion. As it is known, the typical behaviour of power amplifiers is characterized by the fact that as the input power is increased, the gain will be compressed (AM/AM distortion) whereas the phase undergoes an expansion (AM/PM distortion).

Now, if bias voltage V_{DS} is increased with power being equal, the phase changes in a direction which is opposite to the direction in which it changes when the input signal increases; the phase variation as a function of bias voltage V_{DS} is mainly due to the variation of the gate-source capacity that increases as the drain voltage increases (as pointed out e.g. in "Improvement of intermodulation distortion in microwave MESFET amplifiers using gate-bias compensation", Electronics Letters, 9 Nov. 1979, Vol. 15, no. 23, page 742). Based on this fact, a practically constant phase trend will be obtained if bias voltage V_{DS} is increased as the input signal increases.

Therefore, beside a rather improved energy efficiency also a considerably lower phase distortion will be obtained with the amplifier according to this invention.

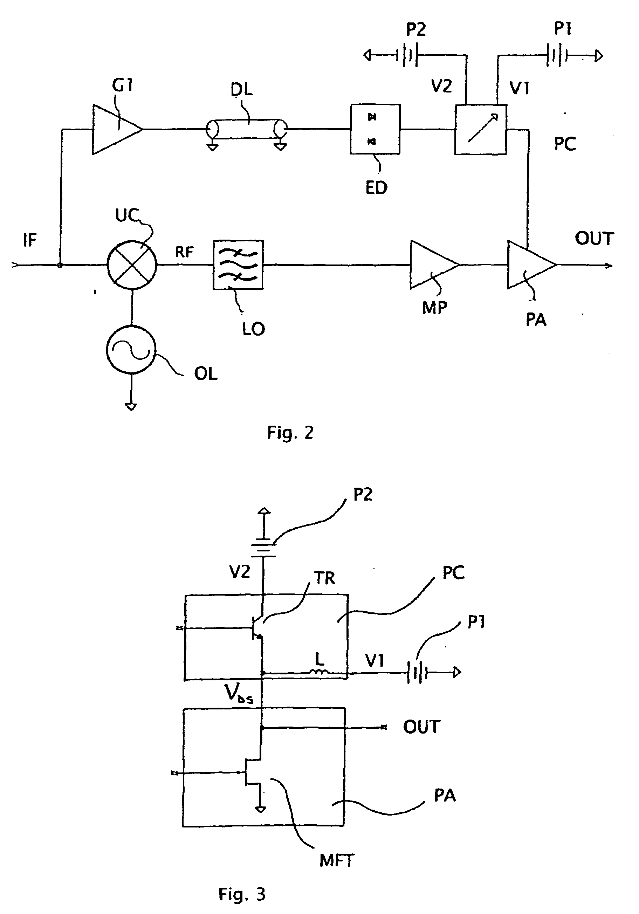

In Fig. 2, showing a block diagram for a high efficiency low distortion microwave power amplifier circuit according to this invention, the reference symbol IF indicates a modulated input signal, which may for instance be a 128 QAM modulated 70 MHz frequency signal having a 151 Mbit/s capacity, whereas an output signal OUT of the microwave power amplifier may be at 13 GHz with 32 dBm power. The symbol UC represents a converter (up-converter) which, in addition to the IF signal also receives the signal of a local oscillator OL, and converts the signal IF in the microwave range through a mixing and amplifying operation.

The signal RF outputting from the microwave converter UC is filtered by a filter LO to attenuate the residual signal at local oscillator frequency; then it will reach a medium power amplifier or driver MP and subsequently the power amplifier PA comprising an MFT power transistor MESFET, such as a 12 W GaAsFET.

The input signal IF is also used to feed a wide-band operational amplifier G1 having a high input impedance in order to avoid that the main circuit be affected; then the signal will go through a delay line DL taking into account the different signal path in the control branch with respect to the main one, thus synchronizing the signal in the control branch with the signal to be amplified.

The symbol ED indicates an envelope detector used to extract the modulation envelope from the input signal IF; it is a conventional diode envelope detector followed by a proper filtering to remove high frequency components.

The symbol PC indicates a phase controller circuit; it receives a control signal from the detector ED and also two different direct voltages, a first voltage V1 and a second voltage V2 (where V2>V1) from two voltage supplies P1 e P2, respectively; the purpose of the controller PC is causing a change of the bias voltage V_{DS} of MFT power MESFET between the two values corresponding to V1 and V2.

The first minimum voltage V1 is determined by way of experiments; the optimal value for the FETs used in the tests was about 6 V. Fig. 3 shows the circuitry diagram of the controller circuit PC and power amplifier PA. The envelope signal obtained from ED is applied to the base of a transistor TR after undergoing an amplitude adjustment and a direct voltage shift; control of the bias voltage V_{DS} of MFT power MESFET is performed by the transistor TR configured as a common collector connected through the collector with the second voltage V2 and the emitter with the drain of the MFT power MESFET. Also voltage V1 is connected with the drain of MFT power MESFET through a properly designed inductor L. Designing of the inductor L plays an important role with a view to reduce consumption; as a matter of fact, thanks to the slow discharge of the inductor L in the very short instants during which the transistor TR is under conduction most current is supplied from the voltage supply P1 to the first lower voltage V1. The transistor TR has to provide the small amount of extra current requested by MFT power MESFET (in addition to that which is supplied by the inductor L) due to the change occurred in the drain current. Thus, the inductor L will allow to draw the most of the current required to operate the MFT power MESFET from the voltage supply P1 at a lower voltage V1. This will result in an advantage, since the voltage supply P2 at a higher voltage V2 can be designed for supplying a power, i.e. a current, which is substantially lower. Moreover, the inductor L operates as a filter for the dynamic part of the bias voltage V_{DS} that does not reach the generator P1, thus removing the need for a protection diode.

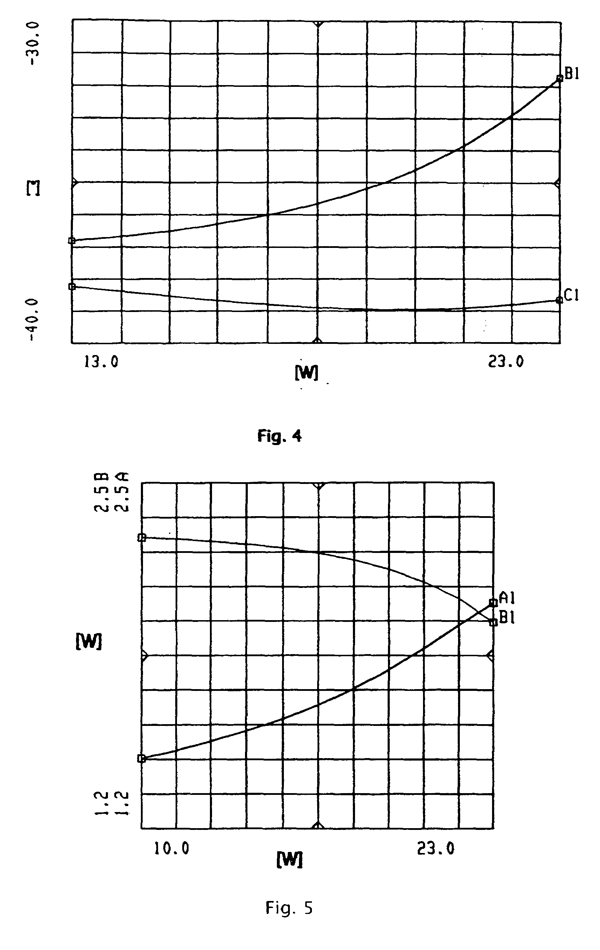

Fig. 4 shows the AM/PM distortion trend under two different conditions, i.e.:
- without bias control circuit and with a constant bias voltage at its maximum value (B1);
- with control circuit PC according to this invention as shown in Figs. 2 and 3 (C1).

As it can be seen, AM/PM distortion will be considerably reduced with the phase controller circuit PC according to this invention, whereas AM/AM distortion remains practically unchanged under both conditions.

Fig. 5 shows the trend of the power absorbed by the amplifier under the same conditions of Fig. 4, i.e. without control circuit (B1) and with control circuit (A1); as it can be seen, if there is a control circuit the absorbed power is proportional to the input signal level and is much lower on average.

Summarizing, the method for driving a linear power amplifier for signals having a high peak power to mean power ratio according to the present invention comprises the steps of providing an envelope detector (ED); detecting input signal (IF) through the envelope detector (ED) to obtain an envelope signal; and using said envelope signal for controlling the supply voltage of a power amplifier device (PA) and is characterized by the steps of sending said envelope signal to a control circuit input (PC); and controlling the supply voltage of the power amplifier device (PA) by said control circuit (PC), the control circuit (PC) being apt to control supply voltage of the power amplifier device (PA) in a proportional continuous way with respect to the envelope signal changes.

Some experimental tests carried out both at 128 QAM, 64 QAM and 32 QAM, have shown that at equal intermodulation it is possible to increase the output power by 3 dB. The following results were obtained with a 13 GHz transmitter using as final FET a 29 dBm rated power FLM1213-12F by Fujitsu Corporation: using the control circuit according to this invention the output power was brought up to 32 dBm; in this case the controller was also feeding the driver MP. Power for the final amplifier changed from 32,9 W to 18,9 W thus obtaining a 42,6% reduction; in addition, a 38% driver saving has been obtained.

Further, a double diode envelope detector was used, detecting both the halfwaves and summing up the second one at 180° with respect to the first one; however no significant improvement was noticed. It was also attempted to convert the signal IF at a higher frequency (700 MHz) for easier detection and filtering.

The detector previously described appears to be more practical as providing the control circuit PC in existing transmitters can be done through minimum changes.

The features of the linear power amplifier described above will be apparent from the above description and annexed drawings.

From this description also the advantages provided by the linear power amplifier according to this invention will be quite clear.

Specifically, they consist in that:
- the energy efficiency of the amplifier is considerably higher on average; specifically, the higher the peak power to the signal mean power ratio, the better it will be;
- a lower operating temperature of the device and consequently an improvement in terms of MTBF (Medium Time Between Failures) will result, i.e. a higher expected life of the device;
- a considerable reduction of AM/PM distortion is obtained through the continuous dynamic dependence of the bias voltage V_{DS} from the envelope signal; at an equal admitted distortion this means that a higher power (about double) can be transmitted.
- the delay line in the circuits providing a lower frequency input and subsequent conversion in the microwaves field can be placed on the circuit branch which is designed for the envelope detection. Said branch operates at a lower frequency if the signal is picked up upstream to the up-converter, so that the delay line is less expensive.
- the circuit according to this invention does not provide conditions where both voltage supplies are not insulated against each other, thus a protection diode is not required.

Obviously, many changes are possible to the power amplifier described by way of example without departing from the invention protection scope and it is also clear that the suggested system can be suitable for any kind of amplifier device, even bipolar amplifiers.

Moreover, it is possible to operate the phase controller under different procedures, i.e. with inverted envelope signals and/or inverted voltage levels of both voltage supplies, always maintaining the characteristic of the dynamic adjustment of the power amplifier operating point proportionally to the envelope signal.

Furthermore, the envelope signal detection should not compulsory occur upstream to the signal conversion in the microwaves field, but it can also be detected downstream at any point of the main node prior to the amplifying device.

## Claims

1. Linear power amplifier circuit for signals having a high peak power to mean power ratio comprising an envelope detector (ED) detecting an input signal (IF) as to obtain an envelope signal, with such signal being used to drive supply voltage of a power amplifier device (PA), and a power amplifier device (PA) having main electrodes causing a bias voltage (V_{DS}) therebetween, and a control circuit (PC) for driving the bias voltage (V_{DS}) between the main electrodes of the power amplifier device (PA) as a function of said envelope signal **characterized in that** said control circuit (PC) is connected to a first voltage supply and a second voltage supply (P1, P2) having respective first and second voltage values (V1, V2) such that said control circuit (PC) is adapted to change the bias voltage (V_{DS}) between said first and second voltage values in such a way as to be proportional to the envelope signal (V1, V2); and wherein an inductor (L) is provided between the first voltage supply (P1) and an electrode of said power amplifier device (PA).

2. Linear power amplifier circuit according to claim 1 **characterized in that** said first voltage value (V1) is a minimum value and said second voltage value (V2) is a maximum value.

3. Linear power amplifier circuit according to claim 1 or 2 **characterized in that** said power amplifier device (PA) comprises a FET transistor (MFT).

4. Linear power amplifier circuit according to claim 3 **characterized in that** said control circuit (PC) comprises a transistor (TR) configured as a common collector for receiving said envelope signal at its base, and is connected through the collector with said second voltage value (V2), through an emitter with the drain electrode of said FET transistor (MFT) and **in that** said inductor (L) is provided for connecting said first voltage value (V1) to the drain electrode of said FET transistor (MFT).

5. Linear power amplifier circuit according to claim 2 **characterized in that** it further comprises a large-band operational amplifier (G1) having high input impedance, said input signal (IF) going through the operational amplifier (G1) before reaching said envelope detector (ED) thus avoiding to affect the main circuit.

6. Linear power amplifier circuit according to claim 5 **characterized in that** it further comprises a delay line (DL) provided on its control branch compensating the different signal path in the control branch with respect to the main branch in order to synchronize the signal to said control circuit (PC) with the signal to be amplified.

7. Linear power amplifier circuit according to any one of the previous claims 2-4, **characterized in that** said control circuit (PC) drives a medium power amplifier (MP) preceding the amplifier device (PA).

8. Linear power amplifier circuit according to claim 6 **characterized in that** it further comprises a mixing and amplifier circuit (UC) in the main branch, the signal being picked up in the control branch upstream the mixing and amplifier circuit (UC) and able to convert the input signal (IF) into a microwave frequency signal.

9. Linear power amplifier circuit according to claim 4 **characterized in that** the inductor (L) is selected in such a way that supply of voltage to the drain electrode of said FET (MFT) is predominantly obtained from the minimum voltage value (V1).

10. A method for driving a linear power amplifier for signals having a high peak power to mean power ratio, comprising the steps of:
- detecting an input signal (IF) through an envelope detector (ED) to obtain an envelope signal;
- sending said envelope signal to a control circuit input (PC);
- controlling the supply voltage of the power amplifier device (PA) by said control circuit (PC), the control circuit (PC) controlling supply voltage of the power amplifier device (PA) as a function of the envelope signal changes,
**characterized in that** said control circuit (PC) changes the bias voltage (V_{DS}) between a first and a second voltage values (V1, V2) supplied respectively from a first voltage supply and a second voltage supply (P1, P2) in such a way as to be proportional to the envelope signal; and wherein the fist voltage supply (P1) supplies the first voltage value (V1) through an inductor (L) provided between said fist voltage supply (P1) and an electrode of said power amplifier device (PA).

11. Method for driving a linear power amplifier according to claim 10, **characterized in that** the control circuit (PC) changes the supply voltage of the power amplifier device (PA) in a way which is linearly proportional to the envelope signal.

12. Method for driving a linear power amplifier according to claim 10, **characterized in that** the first voltage value (V1) is associated with the lowest level of the envelope signal and the second voltage value (V2) is associated with the highest level of the envelope signal.

13. Method for driving a linear power amplifier according to claim 12, **characterized by** picking the signal to be sent to the envelope detector (ED) upstream a mixing and amplifier circuit (UC) which precedes the amplifier device (PA) and converts the input signal (IF) into a microwave frequency signal.

## Patentansprüche

1. Lineare Leistungsverstärkerschaltung für Signale mit einem hohen Verhältnis von Spitzenleistung zur Durchschnittsleistung, die einen Hüllkurven-Detektor (ED) enthält, der ein Eingangssignal (IF) demoduliert, um ein Hüllkurven-Signal zu erhalten, wobei ein solches Signal dazu verwendet wird, die Versorgungsspannung eines Leistungsverstärker-Bauelementes (PA) anzusteuern, und die ein Leistungsverstärker-Bauelement (PA) enthält, das Haupt-Elektroden hat, die eine Vorspannung (V_{DS}) zwischen ihnen verursachen, und die einen Steuerungs-Schaltkreis (PC) enthält, um die Vorspannung (V_{DS}) zwischen den Haupt-Elektroden des Leistungsverstärker-Bauelementes (PA) als Funktion des Hüllkurven-Signals anzusteuern, **dadurch gekennzeichnet, dass** der Steuerungs-Schaltkreis (PC) an eine erste Spannungsversorgung und eine zweite Spannungsversorgung (P1, P2) angeschlossen ist, die entsprechende erste und zweite Spannungswerte (V1, V2) haben, so dass der Steuerungs-Schaltkreis (PC) so angepasst ist, dass er die Vorspannung (V_{DS}) zwischen dem ersten und dem zweiten Spannungswert (V1, V2) auf eine Weise ändert, dass sie proportional zum Hüllkurven-Signal ist, und worin eine Spule (L) zwischen der ersten Spannungsversorgung (P1) und einer Elektrode des Leistungsverstärker-Bauelementes (PA) bereitgestellt wird.

2. Lineare Leistungsverstärkerschaltung gemäß Anspruch 1, **dadurch gekennzeichnet, dass** der erste Spannungswert (V1) ein minimaler Wert und der zweite Spannungswert (V2) ein maximaler Wert ist.

3. Lineare Leistungsverstärkerschaltung gemäß Anspruch 1 oder 2, **dadurch gekennzeichnet, dass** das Leistungsverstärker-Bauelement (PA) einen FET-Transistor (MFT) umfasst.

4. Lineare Leistungsverstärkerschaltung gemäß Anspruch 3, **dadurch gekennzeichnet, dass** der Steuerungs-Schaltkreis (PC) einen Transistor (TR) enthält, der in Kollektorschaltung konfiguriert ist, um an der Basis das Hüllkurven-Signal zu empfangen, und der über den Kollektor mit dem zweiten Spannungswert (V2) und über einen Emitter mit der Haupt-Elektrode des FET-Transistors (MFT) verbunden ist., und in der die Spule (L) bereitgestellt wird, um den ersten Spannungswert (V1) mit der Drain-Elektrode des FET-Transistors (MFT) zu verbinden.

5. Lineare Leistungsverstärkerschaltung gemäß Anspruch 2, **dadurch gekennzeichnet, dass** sie weiterhin einen Breitband-Operationsverstärker (G1) enthält, der eine hohe Eingangsimpedanz hat, wobei das Eingangssignal (IF) den Operationsverstärker (G1) durchläuft, bevor es den Hüllkurven-Detektor (ED) erreicht, wodurch eine Beeinflussung des Haupt-Schaltkreises vermieden wird.

6. Lineare Leistungsverstärkerschaltung gemäß Anspruch 5, **dadurch gekennzeichnet, dass** sie weiterhin eine Verzögerungsleitung (DL) enthält, die in ihrem Steuerungs-Zweig bereitgestellt wird und den unterschiedlichen Signalpfad im Steuerungs-Zweig bezogen auf den Haupt-Zweig kompensiert, um das Signal zu dem Steuerungs-Schaltkreis (PC) mit dem zu verstärkenden Signal zu synchronisieren.

7. Lineare Leistungsverstärkerschaltung gemäß einem beliebigen der vorherigen Ansprüche 2-4, **dadurch gekennzeichnet, dass** der Steuerungs-Schaltkreis (PC) einen Leistungsverstärker mittlerer Leistung (MP) ansteuert, der vor dem Verstärkungs-Bauelement (PA) liegt.

8. Lineare Leistungsverstärkerschaltung gemäß Anspruch 6, **dadurch gekennzeichnet, dass** sie weiterhin einen Mischungsund Verstärker-Schaltkreis (UC) im Haupt-Zweig enthält, wobei das Signal im Steuerungs-Zweig in Aufwärtsrichtung vom Mischungs- und Verstärker-Schaltkreis (UC) entnommen wird, und der in der Lage ist, das Eingangssignal (IF) in ein Signal mit Mikrowellen-Frequenz umzuwandeln.

9. Lineare Leistungsverstärkerschaltung gemäß Anspruch 4, **dadurch gekennzeichnet, dass** die Spule (L) auf eine solche Weise ausgewählt wird, dass die Versorgungsspannung für die Drain-Elektrode des FET (MFT) vornehmlich von dem minimalen Spannungswert (V1) erhalten wird.

10. Ein Verfahren zur Ansteuerung eines linearen Leistungsverstärkers für Signale mit einem hohen Verhältnis von Spitzenleistung zur Durchschnittsleistung, das folgende Schritte umfasst:
- Demodulation eines Eingangssignals (IF) mit einem Hüllkurven-Detektor (ED), um ein Hüllkurven-Signal zu erhalten;
- Senden des Hüllkurven-Signals an einen Eingang eines Steuerungs-Schaltkreises (PC);
- Steuerung der Versorgungsspannung des Leistungsverstärker-Bauelementes (PA) durch den Steuerungs-Schaltkreis (PC), wobei der Steuerungs-Schaltkreis (PC) die Versorgungsspannung des Leistungsverstärker-Bauelementes (PA) als Funktion der Änderungen des Hüllkurven-Signals steuert,
**dadurch gekennzeichnet, dass** der Steuerungs-Schaltkreis (PC) die Vorspannung (V_{DS}) zwischen einem ersten und einem zweiten Spannungswert (V1, V2), die von einer ersten Spannungsversorgung, bzw. einer zweiten Spannungsversorgung (P1, P2) geliefert werden, auf eine Weise ändert, dass sie proportional zum Hüllkurven-Signal ist, und worin die erste Spannungsversorgung (P1) den ersten Spannungswert (V1) über eine Spule (L) liefert, die zwischen der ersten Spannungsversorgung (P1) und einer Elektrode des Leistungsverstärker-Bauelementes (PA) bereitgestellt wird.

11. Verfahren zur Ansteuerung eines linearen Leistungsverstärkers gemäß Anspruch 10, **dadurch gekennzeichnet, dass** der Steuerungs-Schaltkreis (PC) die Versorgungsspannung des Leistungsverstärker-Bauelementes (PA) auf eine Weise ändert, die linear proportional zum Hüllkurven-Signal ist.

12. Verfahren zur Ansteuerung eines linearen Leistungsverstärkers gemäß Anspruch 10, **dadurch gekennzeichnet, dass** der erste Spannungswert (V1) dem kleinsten Pegel des Hüllkurven-Signals zugeordnet ist, und dass der zweite Spannungswert (V2) dem größten Pegel des Hüllkurven-Signals zugeordnet ist.

13. Verfahren zur Ansteuerung eines linearen Leistungsverstärkers gemäß Anspruch 12, **dadurch gekennzeichnet, dass** das zum Hüllkurven-Detektor (ED) zu sendende Signal in Aufwärtsrichtung von einem Mischungs- und Verstärkungs-Schaltkreis (UC) entnommen wird, der vor dem Leistungsverstärker-Bauelement (PA) liegt und das Eingangssignal (IF) in ein Signal mit Mikrowellen-Frequenz umwandelt.

## Revendications

1. Circuit amplificateur de puissance linéaire pour des signaux ayant un haut rapport puissance de crête/puissance moyenne comprenant un détecteur d'enveloppe (ED) détectant un signal d'entrée (IF) de manière à obtenir un signal d'enveloppe, ce signal étant utilisé pour commander la tension d'alimentation d'un dispositif amplificateur de puissance (PA), et un dispositif amplificateur de puissance (PA) ayant des électrodes principales produisant une tension de polarisation (V_{DS}) entre elles, et un circuit de commande (PC) pour commander la tension de polarisation (V_{DS}) entre les électrodes principales du dispositif amplificateur de puissance (PA) en fonction dudit signal d'enveloppe **caractérisé en ce que** ledit circuit de commande (PC) est connecté à une première alimentation de tension et à une deuxième alimentation de tension (P1, P2) ayant des première et deuxième valeurs de tension respectives (V1, V2) de telle sorte que ledit circuit de commande (PC) soit adapté pour changer la tension de polarisation (V_{DS}) entre lesdites première et deuxième valeurs de tension de façon à ce qu'elle soit proportionnelle au signal d'enveloppe (V1, V2) ; et dans lequel un inducteur (L) est fourni entre la première alimentation de tension (P1) et une électrode dudit dispositif amplificateur de puissance (PA).

2. Circuit amplificateur de puissance linéaire selon la revendication 1, **caractérisé en ce que** ladite première valeur de tension (V1) est une valeur minimum et ladite deuxième valeur de tension (V2) est une valeur maximum.

3. Circuit amplificateur de puissance linéaire selon la revendication 1 ou 2, **caractérisé en ce que** ledit dispositif amplificateur de puissance (PA) comprend un transistor TEC (MFT).

4. Circuit amplificateur de puissance linéaire selon la revendication 3, **caractérisé en ce que** ledit circuit de commande (PC) comprend un transistor (TR) configuré en tant que collecteur commun pour recevoir ledit signal d'enveloppe à sa base, et est connecté par le biais du collecteur à ladite deuxième valeur de tension (V2), par le biais d'un émetteur à l'électrode de drain dudit transistor TEC (MFT) et **en ce que** ledit inducteur (L) est fourni pour connecter ladite première valeur de tension (V1) à l'électrode de drain dudit transistor TEC (MFT).

5. Circuit amplificateur de puissance linéaire selon la revendication 2, **caractérisé en ce qu'**il comprend en outre un amplificateur opérationnel à large bande (G1) ayant une impédance d'entrée élevée, ledit signal d'entrée (IF) passant par l'amplificateur opérationnel (G1) avant d'atteindre ledit détecteur d'enveloppe (ED) évitant ainsi d'affecter le circuit principal.

6. Circuit amplificateur de puissance linéaire selon la revendication 5, **caractérisé en ce qu'**il comprend en outre une ligne à retard (DL) fournie sur sa branche de commande compensant le trajet de signal différent dans la branche de commande par rapport à la branche principale afin de synchroniser le signal allant audit circuit de commande (PC) avec le signal à amplifier.

7. Circuit amplificateur de puissance linéaire selon l'une quelconque des revendications précédentes 2 à 4, **caractérisé en ce que** ledit circuit de commande (PC) commande un amplificateur de puissance moyenne (MP) précédant le dispositif amplificateur (PA).

8. Circuit amplificateur de puissance linéaire selon la revendication 6, **caractérisé en ce qu'**il comprend en outre un circuit de mélange et d'amplification (UC) dans la branche principale, le signal étant prélevé dans la branche de commande en amont du circuit de mélange et d'amplification (UC) et pouvant convertir le signal d'entrée (IF) en un signal hyperfréquence.

9. Circuit amplificateur de puissance linéaire selon la revendication 4, **caractérisé en ce que** l'inducteur (L) est sélectionné de manière à ce que l'alimentation de tension à l'électrode de drain dudit TEC (MFT) est essentiellement obtenue à partir de la valeur de tension minimum (V1).

10. Méthode de commande d'un amplificateur de puissance linéaire pour des signaux ayant un haut rapport puissance de crête/puissance moyenne, comprenant les étapes de :
- détection d'un signal d'entrée (FI) par un détecteur d'enveloppe (ED) pour obtenir un signal d'enveloppe ;
- envoi dudit signal d'enveloppe à une entrée de circuit de commande (PC) ;
- commande de la tension d'alimentation du dispositif amplificateur de puissance (PA) par ledit circuit de commande (PC), le circuit de commande (PC) commandant la tension d'alimentation du dispositif amplificateur de puissance (PA) en fonction des changements du signal d'enveloppe,
**caractérisée en ce que** ledit circuit de commande (PC) change la tension de polarisation (V_{DS}) entre une première et une deuxième valeurs de tension (V1, V2) fournies respectivement à partir d'une première alimentation de tension et d'une deuxième alimentation de tension (P1, P2) de manière à ce qu'elle soit proportionnelles au signal d'enveloppe ; et dans laquelle la première alimentation de tension (P1) fournit la première valeur de tension (V1) par le biais d'un inducteur (L) fourni entre ladite première alimentation de tension (P1) et une électrode dudit dispositif amplificateur de puissance (PA).

11. Méthode de commande d'un amplificateur de puissance linéaire selon la revendication 10, **caractérisée en ce que** le circuit de commande (PC) change la tension d'alimentation du dispositif amplificateur de puissance (PA) d'une manière qui est linéairement proportionnelle au signal d'enveloppe.

12. Méthode de commande d'un amplificateur de puissance linéaire selon la revendication 10, **caractérisée en ce que** la première valeur de tension (V1) est associée au plus bas niveau du signal d'enveloppe et la deuxième valeur de tension (V2) est associée au plus haut niveau du signal d'enveloppe.

13. Méthode de commande d'un amplificateur de puissance linéaire selon la revendication 12, **caractérisée par** le prélèvement du signal à envoyer au détecteur d'enveloppe (ED) en amont d'un circuit de mélange et d'amplification (UC) qui précède le dispositif amplificateur (PA) et convertit le signal d'entrée (IF) en un signal hyperfréquence.
